# EUROPEAN PATENT APPLICATION

(11) **EP 0 529 717 A2**
(43) Date of publication of application: **03.03.1993**
(21) Application number: 92202522.6
(22) Date of filing: 18.08.1992
(51) Int. Cl.: H01L 21/311, H01L 21/90

(54) **Method of manufacturing a semiconductor device having overlapping contacts**

(30) Priority: 23.08.1991 EP 91202158
(71) Applicant: Philips Electronics N.V., 5621 BA Eindhoven (NL)
(72) Inventor: Woerlee, Pierre Hermanus, NL-5656 AA Eindhoven (NL); Verhaar, Robertus Dominicus Joseph, NL-5656 AA Eindhoven (NL)
(74) Representative: Rensen, Jan Geert

(57) **Abstract**

A method of manufacturing a semiconductor device whereby a layer structure 7, 8,9 with a lower layer 7 comprising silicon oxide, a silicon intermediate layer 8, and an upper layer 9 comprising silicon oxide is provided on a surface 1 of a silicon body 2 which is bounded by semiconductor regions 3,4 and insulating regions 5, 6, after which contact holes 10 are etched into this layer structure, the intermediate layer 8 serving as an etching stopper layer during etching of the upper layer 9, and the lower layer 7 serving as an etching stopper layer during etching of the intermediate layer 8, and after which a pattern of electrical conductors 11, 12, 13 is provided on the upper layer 9, which conductors make contact with the semiconductor regions 3, 4 through the contact holes 10. Before the upper layer 9 is provided, the intermediate layer 8 is etched into a pattern with separate parts 14 which extend at the area of and in a rim 15 around the contact holes 10. Thus contacts 10 may be realised which lie above semiconductor regions 3, 4 as well as above insulating regions 5, 6.

## Description

The invention relates to a method of manufacturing a semiconductor device whereby a layer structure of a lower layer comprising silicon oxide, an intermediate layer of silicon, and an upper layer comprising silicon oxide is provided on a surface of a silicon body which is bounded by semiconductor regions and insulating regions, after which contact holes are etched into this layer structure, the intermediate layer serving as an etching stopper layer during etching of the upper layer, and the lower layer serving as an etching stopper layer during etching of the intermediate layer, and after which a pattern of electrical conductors is provided on the upper layer, which conductors make contact with the semiconductor regions through the contact holes.

The semiconductor regions may be doped semiconductor zones situated in the silicon body, such as source and drain zones of transistors, but alternatively they may be conductor tracks of doped polycrystalline silicon situated on the semiconductor body, such as gate electrodes of transistors. The insulating regions may be insulating regions situated in the semiconductor body, such as field oxide regions, but alternatively they may be insulating regions situated on the semiconductor body, such as regions for the insulation of the gate electrodes mentioned above. The upper and lower layers comprising silicon oxide of the layer structure may be made of silicon oxide, silicon oxynitride, or of glass, which may comprise boron and phosphorus. The silicon intermediate layer may be made of polycrystalline or amorphous silicon.

The contacts between the pattern of electrical conductors provided on the layer structure and the semiconductor regions may be realised in locations which lie above a semiconductor region as well as above an adjoining insulating region. Such contacts, also called overlapping contacts, render the manufacture of integrated circuits having a very high packing density possible. The silicon intermediate layer is used as an etching stopper layer during etching of the contact holes through the comparatively thick upper layer. Thus the manufacture of the said overlapping contact is possible. If the etching stopper layer should be absent, for example, field oxide regions could also be attacked by the etchant during etching of the upper and lower layers comprising silicon oxide and forming one layer then, so that shallow pn-junctions could be exposed in the semiconductor regions and subsequently short-circuited by the pattern of conductors making contact with the semiconductor regions through the contact holes. In the method mentioned in the opening paragraph, etching of the comparatively thick upper layer stops at the intermediate layer, and etching of the intermediate layer at the lower layer of silicon oxide. Since this latter layer may be comparatively thin, the said risk of exposure and subsequent short-circuiting of shallow pn-junctions is avoided by the use of the silicon etching stopper layer.

JP-A 1/37852 discloses a method of the kind mentioned in the opening paragraph in which a layer of polycrystalline silicon is used as the intermediate layer. After etching of the contact holes in the upper layer and in the intermediate layer, the silicon of the intermediate layer remaining outside the contact holes is converted into silicon oxide by a heat treatment. It is avoided in this way that the silicon of the intermediate layer remaining outside the contact holes has undesirable effects. The polycrystalline silicon is electrically conductive and can accordingly cause short-circuits. The remaining layer may also form an undesirable gate for transistors provided in the semiconductor body. The conversion of the polycrystalline silicon into silicon oxide renders the intermediate layer electrically inactive.

The electrical inactivation of the silicon intermediate layer by its conversion into silicon oxide has the disadvantage that during the oxidation of the silicon of the intermediate layer oxidation of the silicon in the semiconductor region situated inside the contact window will also take place. This silicon is then still coated by the lower layer of silicon oxide, but this layer is much thinner than the layer of silicon oxide covering the intermediate layer. This oxidation may then lead to an undesirable, strong diffusion of dopants into the semiconductor body (oxidation enhanced diffusion). Apart from this undesirable diffusion, the conversion of silicon into silicon oxide, which has a greater specific volume than silicon, may introduce undesirable stresses into the semiconductor body.

The invention has for its object *inter alia* to counteract the said disadvantages. According to the invention, the method mentioned in the opening paragraph is for this purpose characterized in that the intermediate layer is etched into a pattern having separate parts which extend at the area of and in a rim around the contact holes before the upper layer is provided. The size of the rim depends on the photolithographical technique to be used for the manufacture of the semiconductor device. Tolerances of the said manufacturing process are to be taken into account in the dimensioning of this rim.

The separate parts of the intermediate layer can serve as etching stoppers during etching of the contact holes in the upper layer of silicon oxide, so that overlapping contacts can be realised. After etching of the contact holes through the separate parts of the intermediate layer, only silicon remains of this layer around the contact holes, so that this silicon cannot cause any short-circuits or undesirable transistor gates. The remaining silicon, accordingly, need not be rendered neutral. The undesirable heat treatment can be dispensed with.

The separate parts may be formed in an intermediate layer of polycrystalline silicon or of amorphous silicon. According to the invention, however, they are preferably formed in an intermediate layer of amorphous silicon. Such a layer is capable on account of its dense structure of protecting the subjacent silicon oxide layer against an etching bath containing HF. A layer of polycrystalline silicon is not capable of this because of its less dense structure, so that subjacent layers may become etched where this is not desired. An etching bath containing HF is frequently used in practice during an aftertreatment for giving a plasma-etched contact hole less steep walls.

Preferably, the intermediate layer is further doped with an n-type dopant to a concentration of more than 10²⁰ atoms per cm³. Such a strongly doped layer forms a good diffusion barrier against, among other substances, boron. This measure accordingly renders it possible to use a glass containing boron for the upper layer without the risk of boron entering the semiconductor body. A glass containing boron may be made to flow by means of a heat treatment, so that a comparatively plane surface can be formed, which is often desirable in the manufacture of semiconductor devices.

The invention is explained in more detail below by way of example with reference to a drawing, in which:

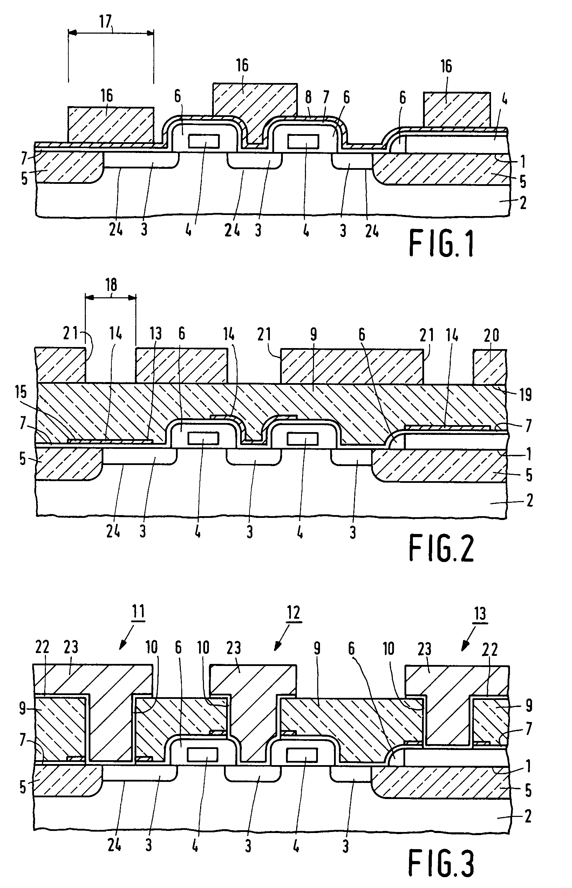

Figs. 1 to 3 diagrammatically and in cross-section show a few consecutive stages of manufacture of a semiconductor device manufactured by the method according to the invention.

Figs. 1 to 3 diagrammatically and in cross-section show a few stages in the manufacture of a semiconductor device manufactured by a method according to which on a surface 1 of a silicon body 2, which is bounded by semiconductor regions 3, 4 and insulating regions 5, 6, a layer structure 7, 8, 9 is provided with a lower layer 7 comprising a silicon oxide, a silicon intermediate layer 8, and an upper layer 9 comprising silicon oxide. The semiconductor regions 3,4 may be doped semiconductor zones 3 situated in the silicon body 2, such as source and drain zones of transistors, but alternatively they may be conductor tracks 4 of doped polycrystalline silicon situated on the semiconductor body 2, such as gate electrodes of transistors. The insulating regions 5, 6 may be insulating regions situated in the semiconductor body, such as field oxide regions 5, but alternatively they may be insulating regions situated on the semiconductor body 2, such as regions 6 for the insulation of the gate electrodes 4 mentioned above.

First the lower layer 7 and the intermediate layer 8 of the layer structure 7, 8,9 are deposited in usual manner. For example, a lower layer 7 of silicon oxide having a thickness of approximately 25 nm is deposited by a low-pressure CVD (Chemical Vapour Deposition) process at a temperature of 400 to 450° C from a gas phase with SiH₄ and O₂, and an intermediate layer 8 of amorphous silicon having a thickness of approximately 50 nm is deposited by a low-pressure CVD process at a temperature of 550 to 600° C from a gas phase with SiH₄. Later, the upper layer 9 having a thickness of approximately 25 nm is deposited, for example, by a low-pressure CVD process at a temperature of 650 to 750° C from a gas phase with tetraethoxy siloxane (TEOS). Preferably, a glass containing boron is used since this can be made to flow by means of a heat treatment, so that a comparatively plane surface can be formed, which is often desirable in the manufacture of semiconductor devices. Such a layer may be manufactured in that B₂H₆ is added to the gas phase during the CVD process.

Contact holes 10 are etched into the layer structure 7, 8, 9, the intermediate layer 8 serving as an etching stopper layer during etching of the upper layer 9, after which the lower layer 7 serves as an etching stopper layer during etching of the intermediate layer. The upper layer 9 of silicon oxide is etched, for example, in a usual plasma containing CHF₃ with high selectivity relative to silicon, the intermediate layer 8 in a usual plasma containing Cl₂ with high selectivity relative to silicon oxide. So etching stops automatically each time at the subjacent layer. After etching of the contact holes 10, a pattern of electrical conductors 11 is provided on the upper layer 10, which conductors make contact with the semiconductor regions 3,4 through the contact holes 10.

Before the upper layer 9 is provided, the intermediate layer 8 of silicon is etched into a pattern comprising separate parts 14 which extend at the area of and in a rim 15 around the contact holes 10 according to the invention. This is done in usual manner by means of an etching process in which portions of the layer 8 not covered by a photoresist mask 16 are removed. The photoresist mask 16 covers a portion of the layer 8 having a diameter 17, being larger than the diameter 18 of the contact hole 10. The size of the rim 15 depends on the photolithographical technique to be used for the manufacture of the semiconductor device. Tolerances of the said manufacturing process are to be taken into account in the dimensioning of this rim. If a photolithographical process is used, for example, by which details of approximately 1 µm can be imaged, these details can be realised in practice in a desired location on the surface of the semiconductor body with a tolerance of approximately 0,5 µm. In that case the rim 15 must be 0,5 µm wide to ensure that etching is always stopped by the part 14 of the intermediate layer 8 during etching of the contact hole 10 in the upper layer 9.

The upper layer 9 is provided after etching of the intermediate layer 8, during which the parts 14 were formed. This upper layer 9 is planarized in usual manner, so that this layer will have a plane surface 19. A subsequent photoresist mask 20 is provided thereon with openings 21 defining the location and the diameter 18 of the contact holes 10. These contact holes 10 are then etched through the upper layer 9, the parts 14 of the intermediate layer 8 serving as an etching stopper layer, then through these parts 14, during which the lower layer serves as an etching stopper layer, and finally through the lower layer 7. If the parts 12 of the intermediate layer 8 should be absent, for example, field oxide regions 5 could also be attached by the etchant during etching of the upper and lower layer comprising silicon oxide which would then form one layer, so that shallow pn-junctions 24 could be exposed in the semiconductor regions and subsequently short-circuited by the conductor pattern 11, 12, 13 making contact with the semiconductor regions 3 through the contact holes 10. In the method mentioned in the opening paragraph, etching of the comparatively thick upper layer 9 stops at the intermediate layer 8, etching of the intermediate layer 8 at the lower layer 7 of silicon oxide. Since this latter layer is comparatively thin, the said risk of exposure and subsequent short-circuiting of shallow pn-junctions is avoided through the use of the etching stopper layer 8 of silicon.

After the realisation of the contact holes 10, the conductor pattern 11 is provided on the upper layer 9 in usual manner. First a comparatively thin layer 22 of TiW and subsequently a layer 23 of Al may be provided, which may subsequently be etched into the desired pattern.

The contacts between the pattern of electrical conductors 11 which is provided on the layer structure 7, 8, 9 and the semiconductor regions 3,4 may be realised in locations which lie above a semiconductor region 3,4 as well as above an adjoining insulating region 5, 6. Such contacts, also called overlapping contacts, render the realisation of integrated circuits with a very high packing density possible. The contact 11 lies above a field oxide region 5 and above a semiconductor region 3 situated in the semiconductor body, the contact 12 lies above a similar semiconductor region 12 and above two regions 6 insulating conductor tracks 4. The contact 13 makes contact with one of the conductor tracks 14, which is deprived of insulation at its upper side for this purpose.

The separate parts 14 may be formed in an intermediate layer 8 of polycrystalline silicon or of amorphous silicon. According to the invention, however, they are preferably formed in an intermediate layer of amorphous silicon. Such a layer is capable on account of its dense structure of protecting the subjacent silicon oxide layer 7 against an etching bath containing HF. A layer of polycrystalline silicon is not capable of this on account of its less dense structure, so that subjacent layers may become etched where this is not desired. An etching bath containing HF is frequently used in practice during an aftertreatment to give a plasma-etched contact hole less steep walls.

Preferably, the intermediate layer 8 is furthermore doped with an n-type dopant to a concentration of more than 10²⁰ atoms per cm³, preferably to a thickness of 20 to 70 nm. This may be done, for example, by carrying out the deposition of the layer by means of a low-pressure CVD process whereby the layer is deposited from a gas phase with SiH₄ and AsH₃. Such a strongly doped layer forms a good diffusion barrier against boron, among other substances. This measure accordingly renders it possible to use a glass containing boron for the upper layer without the risk of boron entering the semiconductor body. A glass containing boron may be made to flow by means of a heat treatment, so that a comparatively plane surface can be formed, which is often desirable in the manufacture of semiconductor devices.

The invention is not limited to the example described. Many variations are possible within the scope of the invention. Thus, in addition to the parts 14 serving as an etching stopper, other, electrically conductive parts may be formed in the intermediate layer 8 which form an electrical connection between contacts, which form a capacitor with conductors lying below or above them, or which locally protect the subjacent semiconductor body against radiation damage which may occur during plasma treatments.

## Claims

1. A method of manufacturing a semiconductor device whereby a layer structure of a lower layer comprising silicon oxide, an intermediate layer of silicon, and an upper layer comprising silicon oxide is provided on a surface of a silicon body which is bounded by semiconductor regions and insulating regions, after which contact holes are etched into this layer structure, the intermediate layer serving as an etching stopper layer during etching of the upper layer, and the lower layer serving as an etching stopper layer during etching of the intermediate layer, and after which a pattern of electrical conductors is provided on the upper layer, which conductors make contact with the semiconductor regions through the contact holes, characterized in that the intermediate layer is etched into a pattern having separate parts which extend at the area of and in a rim around the contact holes before the upper layer is provided.

2. A method as claimed in Claim 1, characterized in that the separate parts are formed in an intermediate layer of amorphous silicon.

3. A method as claimed in Claim 1 or 2, characterized in that the intermediate layer is doped with an n-type dopant to a concentration of more than 10²⁰ atoms per cm³.

4. A method as claimed in Claim 3, characterized in that the intermediate layer is provided with a thickness of between 20 and 70 nm.
